Europäisches Patentamt

(19) European Patent Office

Office européen des brevets

(11) Numéro de publication: **0 020 993**

**B1**

(12) **FASCICULE DE BREVET EUROPEEN**

(45) Date de publication du fascicule du brevet: **30.05.84**

(21) Numéro de dépôt: **80102649.3**

(22) Date de dépôt: **13.05.80**

(51) Int. Cl.³: **G 01 N 27/04,** C 30 B 33/00, H 01 L 21/322, H 01 L 21/324, H 01 L 29/167

(54) Procédé de caractérisation de la teneur en oxygène de barreaux de silicium tirés selon la méthode de Czochralski.

(30) Priorité: **29.06.79 FR 7917302**

(43) Date de publication de la demande:
**07.01.81 Bulletin 81/01**

(45) Mention de la délivrance du brevet:
**30.05.84 Bulletin 84/22**

(84) Etats contractants désignés:
**DE FR GB**

(56) Documents cités:
**EP-A-0 008 661**
**US-A-3 725 148**
**US-A-4 140 570**

**JOURNAL OF CRYSTAL GROWTH, vol. 19, no. 3, 1973, Amsterdam NL F.W. VOLTMER et al. "Anomalous resistivity profiles in long silicon crystals grown by the Czochralski method", pages 215-217**
**SOLID-STATE TECHNOLOGY, vol. 19, no. 5, mai 1976, Washington, US R.B. HERRING "Silicon wafer technology-state of the art 1976", pages 37-42,54**

(73) Titulaire: **International Business Machines Corporation**
**Old Orchard Road**
**Armonk, N.Y. 10504 (US)**

(72) Inventeur: **Cazcarra, Victor**
**51 avenue de Neufville**
**F-91540 Mennecy (FR)**
Inventeur: **Schwab, André**
**24 rue de Bel-Air**
**F-91540 Mennecy (FR)**
Inventeur: **Zunino, Patrick**
**26 rue Alphonse Daudet**
**F-91000 Evry (FR)**

(74) Mandataire: **Klein, Daniel Jacques Henri**
**Compagnie IBM France Département de Propriété Industrielle**
**F-06610 La Gaude (FR)**

(56) References cited:
**IBM TECHNICAL DISCLOSURE BULLETIN, vol. 19, no. 12, mai 1977, New York, US S.M. HU et al. "Gettering by oxygen precipitation", pages 4618-4619**

Courier Press, Leamington Spa, England.

EP 0 020 993 B1

JOURNAL OF APPLIED PHYSICS, vol. 29, no. 8, août 1958, New York, USA C.S. FULLER et al. "Interactions between oxygen and acceptor elements in silicon", pages 1264-1265
JOURNAL OF APPLIED PHYSICS, vol. 35, no. 10, octobre 1964, New York, US G. BEMSKI et al. "Quenched-In Defects in p-Type silicon", pages 2983-2985
PHILIPS RESEARCH REPORTS vol. 31, no. 3, 1976, Eindhoven NL. M.C.H.M. WOUTERS et al. "The electrical conductivity of silicon between 500 C and 1200 C". pages 278-283
APPLIED PHYSICS LETTERS, vol. 36, no. 3, février 1980, New York, US K. YAMAMOTO et al. "Lifetime improvement in Czochralski-grown silicon wafers by the use of a two-step annealing", pages 195-197
JOURNAL OF THE ELECTROCHEMICAL SOCIETY, vol. 126, no. 12, décembre 1979. Princeton, US A. MURGAI et al. "Effect of microscopic growth rate on oxygen microsegregation and swirl defect distribution in Czochralski-grown silicon", pages 2240-2245.

## Description

Domaine Technique

Le domaine technique de présente invention est celui de la fabrication des circuits intégrés à semi-conducteurs. La présente invention se rapporte à un procédé de caractérisation de la teneur en oxygène de barreaux en silicium, tirés selon la méthode de Czochralski, destiné à fournir des tranches à teneur en oxygène contrôlée.

Les tendances actuelles de la micro-électrique qui conduisent à des blocs semi-conducteurs, de plus en plus intégrés, exigent une connaissance de plus en plus poussée en physique du solide, des substrats utilisés. Généralement ces derniers sont en silicium monocristallins obtenu, soit par la méthode de Czochralski, soit par la méthode de zone flottante.

Il est reconnu que les barreaux de silicium tirés selon la méthode de Czochralski (appelés ci-après barreaux CZ) ont une teneur en oxygène supérieure à celle des barreaux obtenus par la méthode dite à zone flottante (appelés ci-après barreaux FZ). En effet cette contamination est provoquée par la réaction du silicium liquide avec les parois en silice du creuset, qui produit du SiO; il en résulte une incorporation non négligeable d'oxygène dans le silicium. Les barreaux CZ ont une teneur moyenne en oxygène comprise entre 2 et $20 . 10^{17}$ atomes/cm$^3$ de silicium, tandis que les barreaux FZ ont une teneur moyenne comprise entre 0,01 et $0,2 . 10^{17}$ atomes/cm$^3$ de silicium. Cette concentration importante en oxygène a pour le silicium des conséquences importantes, tant du point de vue électrique que du point de vue de la pureté cristalline. En effet, en ce qui concerne le premier point, les atomes d'oxygène ont tendance à diffuser lors du tirage et à se regrouper pour former des agglomérats, de composition successive $SiO_2$, $SiO_3$, ..., $SiO_n$. Certains d'entre eux agissent en tant que donneurs, et peuvent donc prendre une part prépondérante dans le type de conductivité et la résistivité du silicium.

La résistivité est un paramètre essentiel du matériau semi-conducteur, on peut déterminer à partir d'elle, les impuretés électriquement actives. La résistivité sera mesurée par la méthode classique dite des quatre pointes. Le type de conductivité sera déterminé par la méthode classique thermoélectrique. Pour donner un ordre de grandeur de la sensibilité de la résistivité à la présence d'oxygène, la génération de $10^{14}$ donneurs par cm$^3$ dans une tranche de type P de résistivité 16 $\Omega$.cm porte sa résistivité à 18 $\Omega$.cm, et la génération de $5.10^{14}$ donneurs/cm$^3$ la portera à 36 $\Omega$.cm; alors qu'une génération de $2.10^{15}$ donneurs/cm$^3$ convertira le matériau de type P en type N, avec une résistivité de 15 $\Omega$.cm. On pourra se référer aux travaux d'Irvin: Bell System Techn. Journal Vol. 41, pp. 387—410, mars 1962 sous le titre: "Resistivity of bulk silicon and of diffused layer".

Par ailleurs, la présence de ces agglomérats dans la structure cristalline peut être source de dislocations et de défauts divers, qui peuvent nuire à la qualité cristalline du matériau et donc à la fiabilité du produit final.

Cependant dans la mesure où le phénomène de contamination est bien contrôlé il est généralement admis que la présence d'oxygène dans les substrats de silicium est généralement bénéfique. Ces agglomérats ou précipités seront ultérieurement utilisés comme centres de piégeage d'impuretés non désirées au cours des différents cycles thermiques que comporte la fabrication de circuits intégrés. Ce problème est décrit en détail dans la demande de brevet européen antérieure EP—A—0 008 661 intitulée: "Procédé pour accroître l'effet de piégeage interne des corps semi-conducteurs".

Dans la présente demande, il ne sera pas tenu compte de la contamination provoquée par les atomes de carbone dont l'influence est certainement plus faible que celle des atomes d'oxygène, mais ne peut cependant être tenue pour négligeable.

La concentration en oxygène interstitiel est généralement mesurée par spectromètrie infrarouge (I.R.) à partir du pic d'adsorption situé à la longueur d'onde de 9 $\mu$m. Un coefficient d'absorption $\alpha_{ox}$ proportionnel à la concentration en oxygène est ainsi obtenu; la constante de proportionnalité sera définie à partir d'échantillons dont le niveau d'oxygène a été mesuré par d'autres techniques (exemple: analyse par activation). Dans notre cas cette constante de proportionnalité, en accord avec les standards américains ASTM, est de 0,63 ppmA/cm$^{-1}$. L'unité ppmA qui signifie "part per million atomic" correspond à $0,5 \times 10^{17}$ atomes par cm$^3$ de silicium. La technique infrarouge est généralement précise, mais des précautions doivent être prises en ce qui concerne l'état de surface de l'échantillon et des corrections liées aux nombres de porteurs doivent être parfois apportées.

Description du problème et état de la technique

Les tranches de silicium obtenues à partir des barreaux CZ, contiennent de l'oxygène, il est essentiel de connaître le comportement de ces tranches lors des différents traitements thermiques ultérieurs auxquels elles seront soumises (diffusion, oxydation, ...), et notamment de comprendre les raisons de certaines modifications notables de la résistivité, ou même du type de conductivité. L'étude de l'influence de l'oxygène sur les propriétés électriques des substrats de silicium CZ a été conduite expérimentalement à l'aide de recuits, effectués à des températures différentes.

Fuller et al (Physical Review *96*, 833 (A) 1955 ont montré que des recuits effectués dans la gamme des températures comprises entre 400 et 500°C avaient un impact considérable sur la résistivité des barreaux CZ.

Pour des température inférieures à 400°C, il y a génération de complexes donneurs, mais pas de maximum sensible même après un recuit de 500h: W. Kaiser et al, Phys. Rev. *112*, 1546, 1958. Ce même auteur a mis en évidence (Phys. Rev. *105*, 1751, 1957) d'une part un maximum pour la génération de donneurs pour un recuit à 450°C, pendant environ 100h et d'autre par le lien entre la concentration initiale d'oxygène et le nombre de complexes donneurs.

On sait également qu'aux environs de 650°C, même pendant un temps relativement court (30 mn), il se produit la destruction de ces complexes électriquement actifs formés à 450°C, les atomes d'oxygène précipitent sous une nouvelle phase électriquement inactive ($SiO_2$). C'est la raison pour laquelle cette température est universellement employée pour le recuit dit de stabilisation, qui fige la résistivité des barreaux CZ. Le recuit de stabilisation peut être également réalisé à 1000°C pendant des temps relativement longs (20h) mais cette température présente évidemment moins d'intérêt que la température de 650°C mentionnée précédemment.

Actuellement le procédé consiste à découper toutes les tranches à partir d'un barreau CZ stabilisé à 650°C et rectifié. Ces tranches sont ensuite rodées, puis polies, et leur niveau d'oxygène est mesuré par des techniques IR, enfin elles sont triées une par une, pour ne garder que les tranches bonnes en spécification oxygène. Ce procédé est très coûteux, et limite considérablement la productivité des lignes "matériaux".

L'état de la technique comprend également les documents suivants:

. un article de F. W. Voltmer et al publié dans le Journal of Crystal Growth, Vol. 19, No. 3, 1973 sous le titre: Anomalous Resistivity Profiles in Long Silicon Crystals Grown by the Czochralski Method, pages 215—217 qui met en évidence que ces anomalies sont dues à la présence de donneurs générés lors des procédés thermiques,

. un article de R. B. Herring publié dans Solid-State Technology, Vol. 19, No. 5, mai 1976, initulé: "Silicon Wafer Technology-State of the Art 1976" pages 37—42, 54; et plus particulièrement page 39, Col. 1, paragraphes 3 et 4 qui décrit un procédé qui réduit les petits amas actifs d'oxygène,

. un article de S. M. Hu et al publié dans l'IBM Technical Disclosure Bulletin, Vol. 19, No. 12, Mai 1977, pages 4618—19 intitulé: "Gettering by Oxygen Precipitation", qui met en évidence que des traitement thermiques à haute température peuvent assurer la précipitation des atomes d'oxygène,

. un article de C. S. Fuller et al publié dans Journal of Applied Physics, Vol. 19, No. 8 août 1958, pages 1264—1265 intitulé: "Interactions Between Oxygen and Acceptor Elements in Silicon" est relatif à la formation de donneurs lors des étapes de traitement thermique, en liaison avec la présence d'atomes d'oxygène.

Enfin, l'état de la technique comprend également les brevets: US—A—4 140 570 et US—A—3 725 148.

La présente invention met à profit ces enseignements développés précédemment en vue de fournir un procédé de caractérisation de la teneur en oxygène des tranches à partir du décalage en résistivité mesuré sur des bouts de barreaux CZ à qui on a fait subir des traitements thermiques spécifiques: à une température comprise entre environ 600°C et 900°C, pendant un temps compris entre environ 1 et 10 heures. Le besoin se fait sentir aujourd'hui d'avoir des tranches de silicium à concentration d'oxygène contrôlée, précipitant plus ou moins rapidement suivant les dispositifs que l'on va fabriquer et qui doivent rester à l'intérieur de spécifications très serrées en résistivité.

Dans une première application aux produits bipolaires on veut détecter les parties de barreaux dont le niveau d'oxygène est supérieur ou inférieur à 35—36 ppmA. Dans une autre application aux produits unipolaires on veut détecter les parties de barreaux dont le niveau d'oxygène est supérieur à 30 ppmA.

Le but de l'invention est d'indiquer un procédé sensible et précis permettant de caractériser la teneur en oxygène des barreaux de silicium afin de ne traiter que la partie qui correspond à la concentration d'oxygène désirée.

Une forme d'exécution de l'invention permet de prévoir la forte précipitabilité en oxygène de certaines tranches découpées à partir de barreaux CZ.

Une autre forme d'exécution de l'invention permet de fournir aux lignes de fabrication des tranches découpées à partir de barreaux CZ, stables en résistivité (ou qui ne varieront que d'une quantité prévue à l'avance).

De façon connue les barreaux CZ sont stabilisés, en résistivité à une température voisine de 600°C (située entre les deux pics de résistivité, 450°C et 750°C qui seront mis en évidence ci-après) et pendant un temps de 0,5 à 3 heures (ce qui évitera toute génération de donneurs).

Dans un procédé selon la revendication 1, à savoir de caractérisation de la teneur en oxygène de barreaux en silicium tisés selon la méthode de Czochralski destinés à fournir des tranches à teneur en oxygène contrôlée, ce but est atteint pas les quatre étapes figurend dans la partie caractérisante de cette revendication. Pratiquement, comme on le verra, la température sera comprise entre 650°C et 850°C et le temps compris entre 1 et 6 heures.

Cette technique de mesure indirecte du niveau d'oxygène nous permettra de reconnaître rapidement les parties des barreaux CZ bonnes en spécification oxygène et par conséquent de ne découper, roder, et polir que des tranches dont on sera certain qu'elles seront utilisables sur les lignes de fabrication.

Dans une réalisation préférée, pour garantir une spécification maximale d'oxygène de 35—36 ppmA, la température de recuit sera de 825°C, le temps voisin de 2 heures et l'incrément de résistivité de la portion découpée en tête de barreau sinon nul du moins très faible. En effet pour une tranche de type p initialement autour de 19 $\Omega$.cm, une génération de $10^{14}$ donneurs/cm$^3$ fait varier sa résistivité de 3 $\Omega$.cm (voir les travaux précités d'Irvin), on se rend compte de la sensibilité du présent procédé.

De plus dans le cas où une génération de précipités est désirée pour accroître le piégeage interne, on pourra suivant les enseignements du brevet No. 78 26223 précité, faire subir au barreau des traitements thermiques adaptés et caractériser la précipitation suivant le procédé décrit dans ce brevet. Toutefois, si les tranches ont été traitées en dessous de 850°C, de très fortes générations de précipités pourront être détectées à partir des variations de résistivité. Ces variations se corrigeront généralement lors des traitements thermiques en lignes de fabrication.

D'autres particularités et avantages afférents à un mode de réalisation préféré de la présente invention ressortiront mieux de l'exposé qui suit, en référence aux dessins annexés à ce texte.

Brève description des figures

La figure 1 représente le nombre de donneurs générés ($N_D$) en fonction de la durée du recuit (t) en heures à 450°C pour diverses concentrations initiales d'oxygène $[\overline{O}]$.

La figure 2 représente le nombre de donneurs générés par heure de recuit (MDGH) en fonction de la concentration initiale d'oxygène $[\overline{O}]$ donnée en ppmA à 450°C.

La figure 3 représente le nombre de donneurs $N_D$ générés en fonction des durées de recuit t en heures, pour différentes températures de recuit pour des tranches présentant une concentration initiale d'oxygène $[\overline{O}]=38{,}3$ ppmA.

Les figures 4, 5, 6, 7 et 8 représentent d'une part le nombre de donneurs générés $N_D$ et d'autre part la précipitation de l'oxygène en ppmA en fonction de la durée de recuit (t), à des températures de recuit respectives de 600°C, 650°C, 750°C, 825°C et 900°C pour diverses concentrations d'oxygène;

La figure 9 représente le nombre de donneurs maximum générés par heure de recuit MDGH en fonction des températures de recuit (t) pour différentes concentrations initiales d'oxygène $[\overline{O}]$.

La figure 10 montre l'évolution du nombre de donneurs générés lors d'un recuit à 450° pendant 20 heures, en fonction du temps t pour un second recuit effectué à 650°C et pour différentes concentrations initiales d'oxygène $[\overline{O}]$ en ppmA.

La figure 11 représente l'annihilation à 1000°C des donneurs générés par un recuit de 5 heures à 750°C en fonction de la durée de recuit (t) pour des tranches ayant différentes concentration initiales d'oxygène $[\overline{O}]$ en ppmA. Les premier et second chiffres indiquent respectivement la concentration initiale et finale en oxygène (en ppmA) c'est-à-dire avant et après le recuit à 750°C.

La figure 12 représente l'évolution des donneurs générés $N_D$ en fonction de la concentration initiale d'oxygène $[\overline{O}]$ à 825°C pour des durées de recuit de 2 heures et de 5 heures.

La figure 13 représente l'évolution des donneurs générés $N_D$ en fonction de la concentration initiale d'oxygène $[\overline{O}]$ pour un recuit de 6 heures à 750°C.

Description de l'invention

1. Génération par traitement thermique de donneurs liés à l'oxygène

a) Autour de 450°C

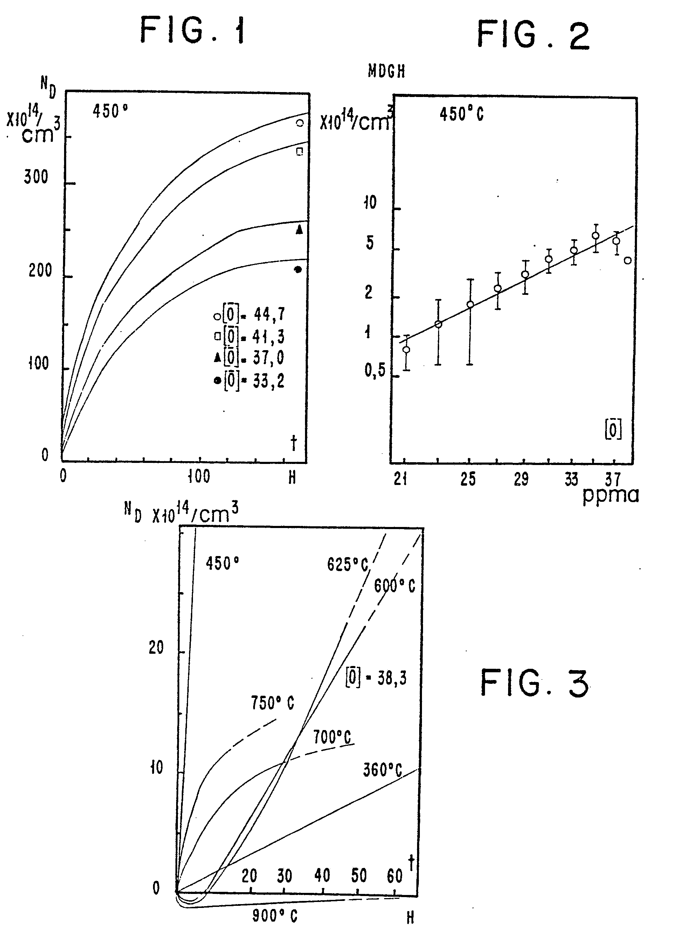

Les travaux de Fuller, cités plus haut avaient posé le problème pour des traitements thermiques voisins de 450°C. Kaiser dans ses diverses publications a proposé des théories explicatives basées sur la génération, à ces températures, de complexes donneurs type $SiO_4$, qui étaient détruits à des températures plus élevées $\simeq 600$°C. Leur génération suivait une loi en $[\overline{O}]^4$ et passait par un maximum, ce qui était conforme aux expériences. Les résultats de la figure 1 confirment les travaux de Kaiser; toutefois les informations sur l'oxygène qu'on peut tirer à partir des variations de résistivité sont trop imprécises (voir les écarts types élevés sur la figure 2) pour être utilisées industriellement.

b) Aux températures supérieures à 450°C

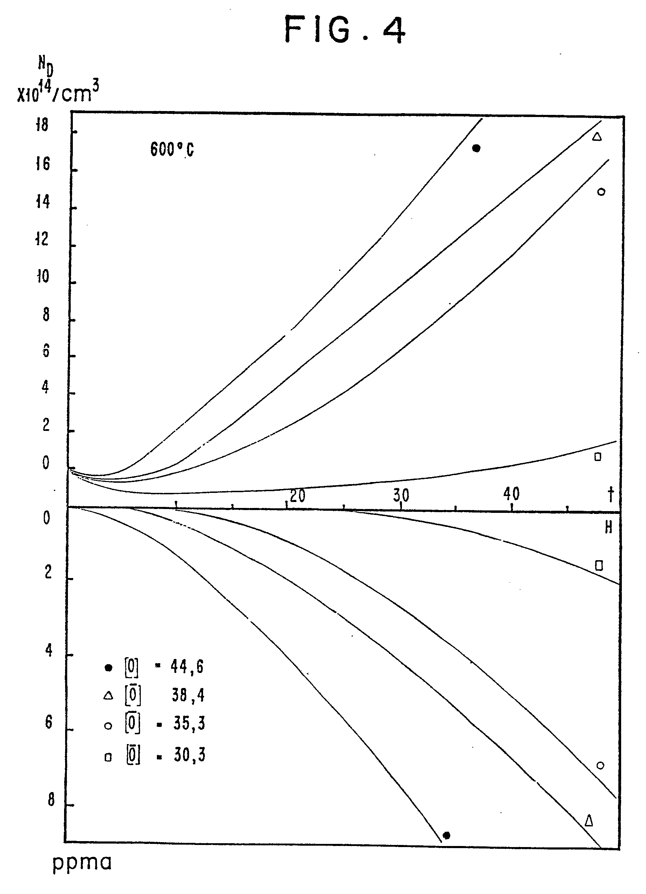

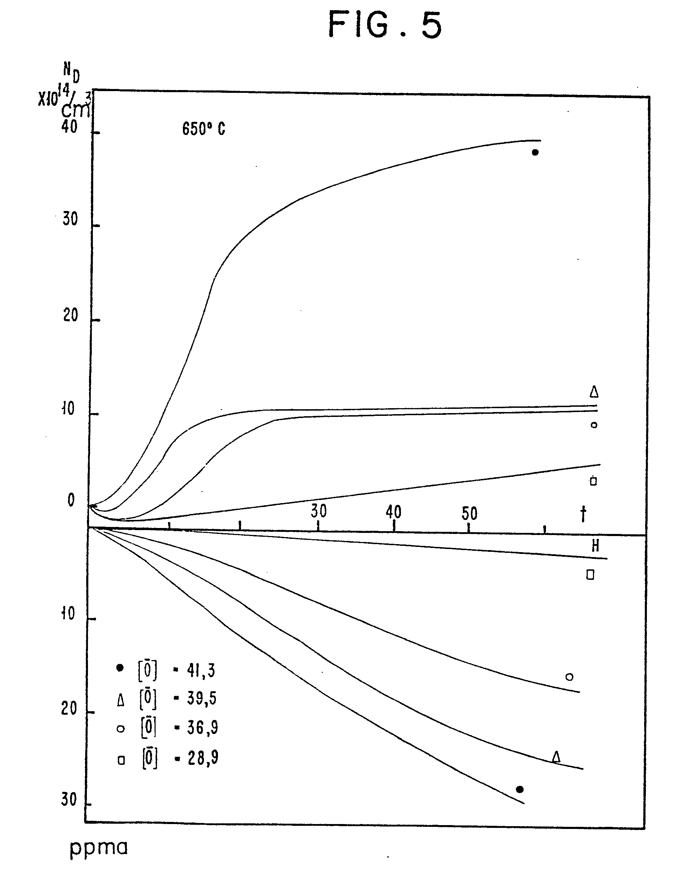

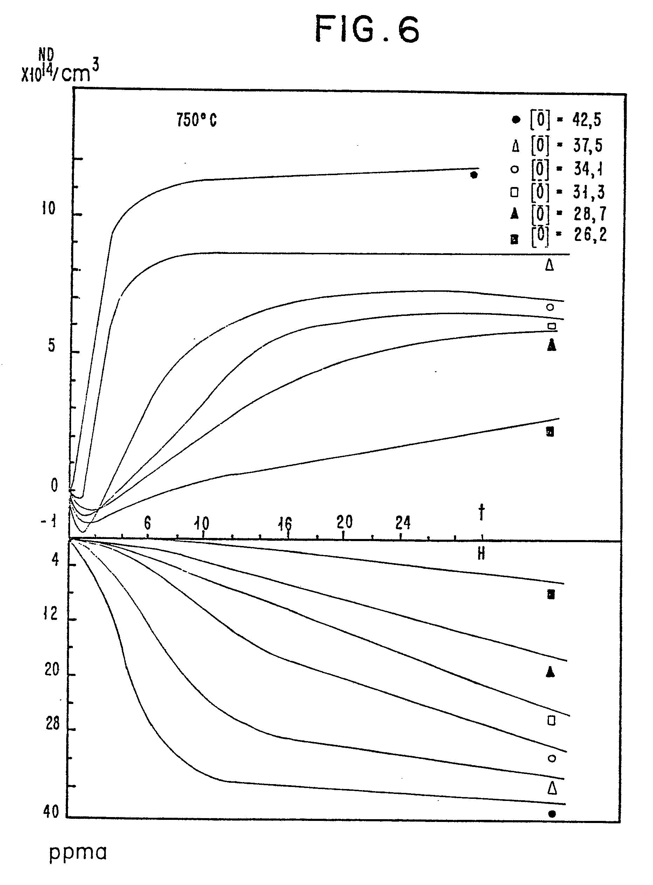

Les courbes représentées sur la figure 3 nous indiquent que, pour des tranches à fort niveau d'oxygène, des donneurs sont générés très rapidement aux températures voisines de 750°C. Les résultats des études systématiques conduites aux températures de 600°C, 650°C, 750°C, 825°C et 900°C sont montrées sur les figures 4 à 8. On peut observer en parallèle une précipitation de l'oxygène qui suit les mêmes lois, exception faite de la température de 900°C; de phénomène n'avait pas été détecté à 450°C.

Par ailleurs, on peut voir sur la figure 4 que pour des temps inférieurs à 5 heures, il n'y a pas de génération de donneurs; c'est pour cette raison qu'il est recommandé de stabiliser la résistivité des barreaux (ou des tranches) à cette température.

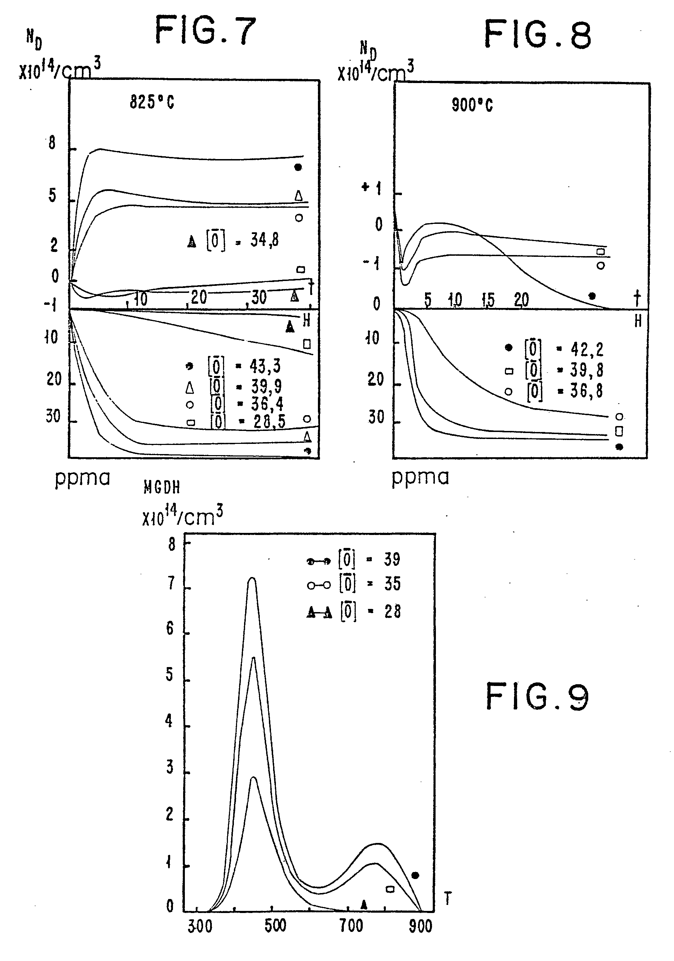

2. Etude du phénomène
a) Pics de résistivité
Pour quantifier le phénomène pour des concentrations initiales d'oxygène différentes, on définit un nouveau paramètre MDGH qui correspond au nombre de donneurs maximum générés par heure de recuit (le MDGH correspond donc à la pente maximale des courbes $N_D=f$ (t) représentées sur les figures 4 à 8). Si on reporte le MDGH en fonction des températures de recuit T allant de 300 à 900°C pour des concentrations [O] différentes, on trouve la très intéressante courbe de la figure 9. On retrouve le pic prévu par Kaiser à 450°C bien connu dans la littérature, mais, ce qui apparaît nouveau, c'est l'existence d'un deuxième pic de résistivité aux environs de 750°C. Ce pic est surtout mis en évidence entre les températures de 650 et 850°C, bien qu'en fait il soit sensible entre 600 et 900°C.

b) Relation entre les deux pics

Quoique tous deux reliés à l'oxygène, les deux pics sont de nature différente pour la raison suivante, la précipitation de l'oxygène n'est observée que lors du second pic.

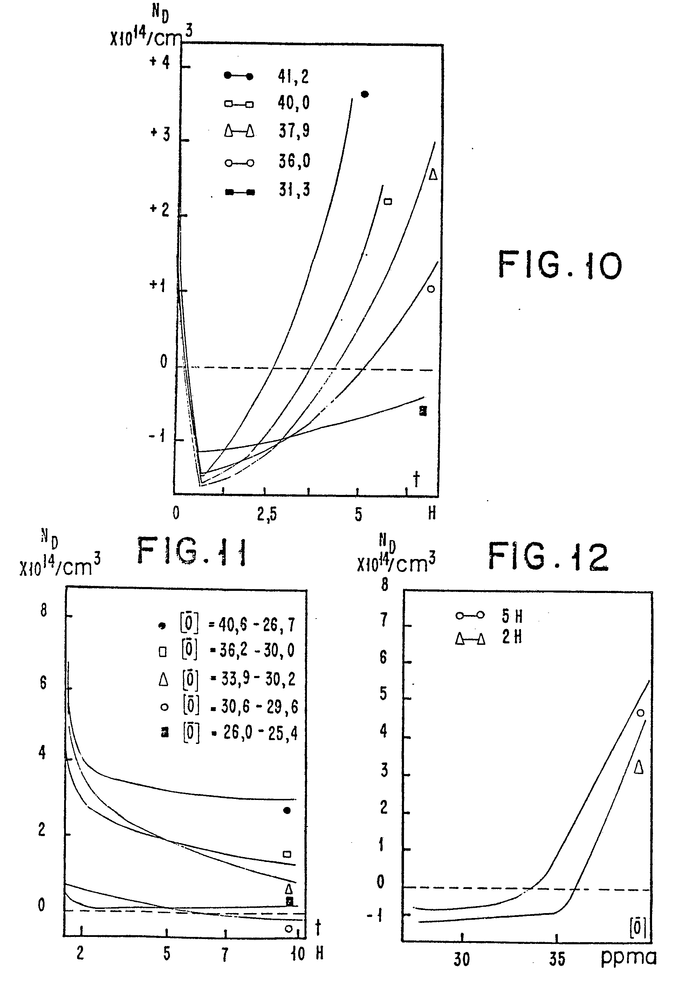

Toutefois, pour confirmer ce point, on a généré des donneurs à 450°C pendant un temps de vingt heures puis on a traité les tranches à 650°C (figure 10). On peut voir que les donneurs générés à 450°C sont complètement détruits avant que les nouveaux (de nature donc différente) soient générés.

c) Stabilité des différents donneurs

Les donneurs relatifs au pic de 450°C sont très parfaitement détruits (comme Kaiser l'a montré ou comme on peut s'en rendre compte sur la figure 10), ils sont de ce fait peu gênants actuellement.

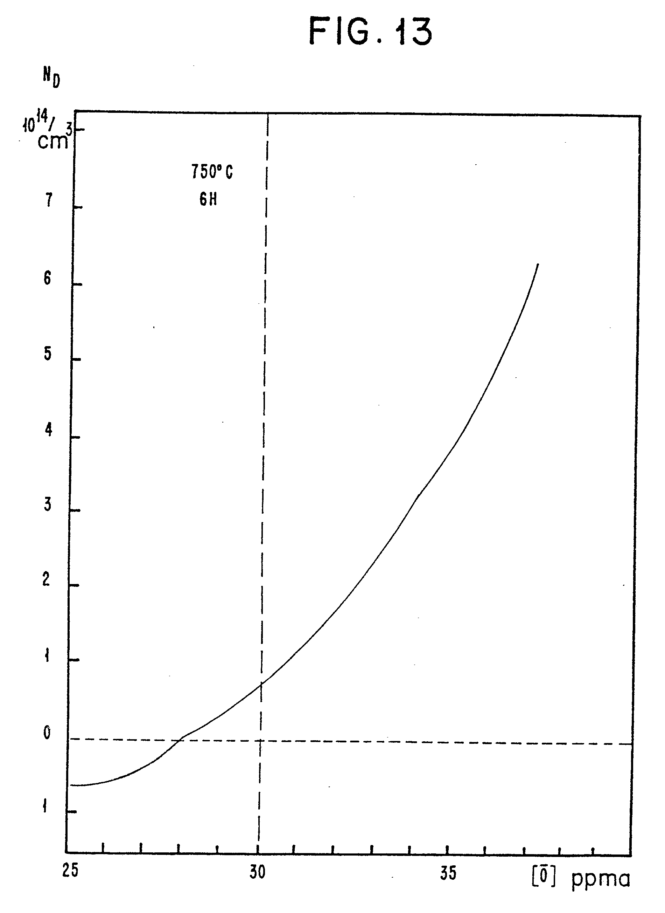

On a vu ci-dessus que la guérison des donneurs générés à 750°C est beaucoup plus difficile que la guérison des donneurs générés à 450°C. Des traitements prolongés à hautes températures sont nécessaires, comme le montre la figure 11, peur les faire disparaître. Le point est effectivement très important ici, pour le contrôle de la résistivité des produits FET, susceptible d'être soumis à des dépôts chimiques en phase vapeur et à basse pression (LPCVD) qui se situent précisément autour de 750°C. Un tel procédé est particulièrement bien décrit dans le brevet français FR—A—2 332 802, déposé par Motorola le 25 novembre 1976 et intitulé: "Procédé pour déposer du nitrure de silicium sous vide".

Dans ce cas on peut choisir de ne garder que les tranches qui ont une teneur en oxygène suffisante pour assurer un piégeage interne (gettering) appréciable.

3. Applications industrielles des résultats montrés sur la figure 9

a) Stabilisation de la résistivité

La meilleure température pour la stabilisation de la résistivité se situera au minimum entre les deux pics soit vers 600°C. Il est souhaitable que les durées soient inférieures à 3 heures.(figure 4) pour éviter toute génération de donneurs. En fait la stabilisation peut être effectuée de façon satisfaisante entre 550 et 650°C avec une durée comprise entre 1 et 5 heures environ.

b) Contrôle du niveau d'oxygène des barreaux CZ et définition du procédé de caractérisation de la teneur en oxygène de ces barreaux

Le problème posé est donc celui de déterminer avec précision la concentration ou teneur en oxygène [O] des barreaux CZ, parce que selon cette teneur on aura (ou on n'aura pas) de génération de donneurs dans les procédés thermiques ultérieurs, qui provoquent des variations souvent non désirées de la résistivité.

Le pic de 450°C n'est pas utilisable à cet effet, les résultats montrés sur la figure 2 sont trop imprécis comme on l'a écrit ci-dessus (paragraphe 1.a).

Par contre, ce qui apparaît avec plus ou moins d'amplitude sur les figures 4 à 8, c'est que l'effet de génération de donneurs est une fonction très sensible de la concentration initiale en oxygène [O]. Sur la figure 7 qui correspond à T=825°C, on voit que la génération de donneurs est pratiquement nulle pour [O]<35 alors qu'elle est très importante pour [O]≥36. La différentiation est donc très nette. En outre, cet effet est très rapidement sensible, il suffit en effet de recuire entre 1 et 10 heures, pratiquement entre 1 et 6 heures, pour que l'on puisse distinguer les comportements. Des temps de recuit supérieur peuvent bien sûr s'envisager mais ils présentent un faible intérêt industriel.

Sur la figure 9, on peut se rendre compte que l'effet de génération de donneurs autour du pic de 750°C est en fait sensible dans la gamme de 600°C à 900°C. Cette dernière correspond pratiquement à la gamme utile. En effet, à 600°C, (figure 4), l'effet existe mais il faut recuire longtemps pour distinguer les différentes concentrations initiales, pratiquement au moins 20 heures, cette température correspond donc à la température limite basse du présent procédé de caractérisation. A 900°C (figure 8) on voit que l'effet de génération de donneurs a pratiquement disparu, cette température n'est quère intéressante et correspond donc à la température limite supérieure du présent procédé.

La teneur en oxygène décroissant généralement de la tête du barreau (près de la semence) vers la queue, on mesurera la valeur maximum sur une portion du barreau, en fait une tranche d'environ 1 cm d'épaisseur, que l'on aura découpée en tête du barreau; (inversement, on mesurera la valeur minimale sur une portion découpée en queue du barreau).

Ce procédé de caractérisation consiste:

1) à découper cette portion en tête du barreau stabilisé (en queue) et à mesurer sa résistivité,

2) à recuire cette portion à une température comprise entre environ 600°C et 900°C pendant un temps compris entre environ 1 et 6 heures sous une atmosphère neutre d'azote par exemple,

3) à décaper chimiquement la surface de cette portion pour exposer le silicium qui a pu être oxydé et mesurer de nouveau la résistivité,

4) si l'incrément de résistivité est supérieur (ou inférieur) à un certain nombre de $\Omega$.cm correspondant à une génération significative de donneurs, par exemple $10^{14}$ donneurs/cm³ qui correspond finalement à une concentration initiale d'oxygène non désirée, à recommence la même procédure après avoir éliminé 3 à 4 cm de barreau, en découpant une nouvelle portion du barreau.

Exemples

Pour les produits bipolaires on veut garantir une spécification de 36 ppmA d'oxygène maximum, ce qui assure l'absence de l'effet de génération de donneurs et même une légère annihilation qui est souhaitable, pour la stabilité de la résistivité du barreau. Dans ce cas la tranche épaisse provenant de la tête du barreau sera recuite par exemple à 825°C pendant approximativement deux heures et l'incrément de résistivité devra être nul ou du moins très faible ce qui correspond à une génération de porteurs nulle ou très faible (voir figure 12). On pourrait définir une valeur critique de l'incrément de résistivité correspondant à une génération significative de donneurs. Par exemple la valeur critique sera de 3 $\Omega$.cm pour un barreau de silicium de type P de 19 $\Omega$.cm ce qui correspond d'après les courbes d'Irvin à la génération de $10^{14}$ donneurs par cm³. Les figures 7 et 12 nous montrent la précision de la mesure (pas d'incrément à 34,8 ppmA et incrément très fort au-dessus de 37 ppmA); comparable à la précision de l'infrarouge qui est de 2 ppmA.

On voit en particulier sur la figure 12 que le recuit à 825°C pendant 2 heures permet de caractériser les tranches ayant une concentration initiale en oxygène inférieure à 36 ppmA tandis qu'une durée de 5 heures est plus appropriée pour la valeur de 33—34 ppmA.

Dans le cas de barreaux destinés aux lignes de fabrication de produits FET, un niveau minimal d'environ 30 ppmA est indispensable pour assurer l'effet de piégeage interne désiré. La tranche épaisse provenant de la queue du barreau sera recuite par exemple à 750°C pendant 6 heures et l'incrément de résistivité devra être sensible pour être certain qu'il y a eu génération de donneurs. Par exemple l'incrément minimal autorisé sera de 3 $\Omega$.cm pour une valeur initiale de résistivité d'un barreau de type P d'environ 19 $\Omega$.cm, ce qui correspond comme on l'a vu ci-dessus à une génération de donneurs de $10^{14}$ donneurs/cm³, valeur qui peut être considérée comme significative. Si l'incrément de résistivité est inférieur on recommencera la même procédure après avoir éliminé 3 à 4 cm du barreau en découpant une nouvelle portion du barreau. La figure 13, nous montre là aussi, la précision de la technique.

Ainsi, ce procédé de caractérisation, associé à un choix judicieux d'une température de recuit (comprise entre 650 et 850°C) et d'une durée de recuit (comprise entre 1 et 6 heures) appropriées, permet de caractériser différents besoins en barreaux. On a donné ci-dessus deux exemples importants pour les lignes de fabrication, mais qui ne sont pas limitatifs.

c) Prévision de la forte précipitabilité des tranches, et des variations de résistivité

Dans le cas où des traitements de génération de précipités ont été faits pour accroître le piégeage interne (suivant la demande EP—A—0 008 661 précité) et que la température choisie est inférieure à 850°C; les tranches à très forte précipitabilité pourront être détectées suite à la variation de résistivité (ceci s'explique facilement vu la relation observée dans les figures 4 à 7 entre la précipitation et l'effet donneur). De plus pour les tranches ayant légèrement évolué on peut prévoir leur valeur finale lorsque les donneurs auront été éliminés durant les traitements en ligne de fabrication.

4. Avantages du procédé de caractérisation

a) Sur le tri en oxygène des tranches

La partie de barreau bonne en spécification d'oxygène est connue sans qu'il y ait à découper et polir des tranches minces d'où un gain considérable de productivité. En effet le procédé utilisé auparavant consistait à découper toutes les tranches à partir d'un barreau CZ stabilisé à 650°C et rectifié. Ces tranches étaient ensuite rodées, puis polies et enfin leur concentration d'oxygène était mesurée par des techniques infrarouge qui demandent un bon état de surface. Un profil d'oxygène était alors établi en fonction d'une gorge en biais qui avait été faite sur le plat de la tranche (voir IBM Technical Disclosure Bulletin, Vol. 20, No. 8, janvier 1978, pages 3154 un article intitulé "Reference mark for locating a wafer in semiconductor rods" par D. Mallejac; les tranches étaient alors triées une à une pour ne garder que les tranches bonnes en spécification d'oxygène. Cette procédure était donc très lourde et coûteuse pour la production, d'où l'intérêt de ce nouveau procédé.

b) Sur la stabilité de la résistivité et la précipitabilité de l'oxygène

La présente étude donne donc des informations précieuses sur ces deux paramètres fondamentaux.

**Revendications**

1. Procédé de caractérisation de la teneur en oxygène de barreaux en silicium tirés selon la méthode de Czochralski destinés à fournir des tranches à teneur en oxygène contrôlée, caractérisé en ce qu'il comporte les étapes suivantes:

1. stabilisation du barreau en résistivité,
2. découpage d'une première portion de barreau voisine d'une première extrémité du barreau et mesure de sa résistivité,
3. recuit de cette portion à une température comprise entre environ 600°C et 900°C pendant un temps suffisant pour générer des donneurs dans une atmosphère chimiquement acutre,
4. décapage de cette portion et détermination de l'incrément de résistivité pour en déduire le concentration initiale d'oxygène $[\overline{O}]$ recherchée qui caractérise la teneur en oxygène du batteau.

2. Procédé selon la revendication 1 caractérisé en ce que la gamme de température pour recuire cette portion est comprise entre 650°C et 850°C et la durée de recuit entre 1 et 6 heures.

3. Procédé de caractérisation selon la revendication 1 ou 2 caractérisé en ce que ladite première extrémité est la tête du barreau et que si l'incrément de résistivité est inférieur à la valeur critique qui correspond à une génération de donneurs significative, la portion restante du barreau est sélectionnée pour être traitée sur les lignes de fabrication de produits bipolaires.

4. Procédé de caractérisation selon la revendication 3 caractérisé en ce que si l'increment de résistivité est supérieur à cette valeur critique on recommence les étapes 1 à 4 avec une nouvelle portion approximativement adjacente à la première portion et plus éloignée de la tête du barreau.

5. Procédé de caractérisation selon la revendication 3 ou 4 caractérisé en ce que pour sélectionner les barreaux qui ont une concentration en oxygène inférieure à 36 ppmA la température de recuit est de 825°C et la durée de recuit voisine de 2 heures.

6. Procédé de caractérisation selon la revendication 1 ou 2 caractérisé en ce que ladite première extrémité est la queue du barreau et que si l'increment de résistivité est supérieur à la valeur critique qui correspond à une génération de donneurs significative, la portion restante du barreau est sélectionnée pour être traitée sur les lignes de fabrication de produits unipolaires.

7. Procédé de caractérisation selon la revendication 6 caractérisé en ce que si l'incrément est inférieur à cette valeur critique, on recommence les étapes 1 à 4 avec une nouvelle portion approximativement adjacente à la première portion et plus éloignée de la queue du barreau.

8. Procédé de caractérisation selon la revendication 6 ou 7 caractérisé en ce que, pour sélectionner des barreaux qui ont une concentration supérieure en oxygène à 30 ppmA la température de recuit est de 750°C et la durée de recuit voisine de 6 heures.

9. Procédé de caractérisation selon l'une quelconque des revendications ci-dessus, caractérisé en ce que la stabilisation du barreau s'effectue à 600°C pendant un temps compris entre 1 et 3 heures.

10. Procédé de caractérisation selon l'une quelconque des revendications ci-dessus, caractérisé en ce que l'atmosphère neutre est l'azote et que l'étape de décapage comprend l'élimination de la mince couche d'oxyde superficiel dans un bain d'acides $NO_3H + HF$.

11. Procédé de caractérisation selon l'une quelconque des revendications 3 à 10 ci-dessus, caractérisé en ce que la génration significative de donneurs correspond à la génération de $10^{14}$ donneurs/$cm^3$.

12. Procédé de caractérisation selon la revendication 11 caractérisé en ce que la valeur critique est égale à 3 ohms.cm pour une tranche de 19 ohms.cm de résistivité.

13. Procédé de caractérisation selon l'une quelconque des revendications ci-dessus, caractérisé en ce que la première portion est une tranche épaisse de barreau d'épaisseur 1 cm environ.

## Claims

1. Method for characterizing the oxygen contents of Czochralski grown silicon rods to be cut into wafers characterized in that it includes the following steps:

1— Stabilizing the rod resistivity,
2— Cutting a first portion of the rod close to a first end of the rod an measuring its resistivity,
3— Annealing this portion at a temperature of between approximately 600 and 900°C for a period of time sufficient to generate donors in a chemically neutral atmosphere,
4— Etching this portion and determining the resistivity increment to deduce the required initial oxygen concentration $[\overline{O}]$ thereof, which characterizes the rod oxygen contents.

2. Method according to claim 1 characterized in that the temperature range for annealing said portion goes from 650 to 850°C and the annealing duration range from 1 to 6 hours.

3. Method according to claim 1 or 2 characterized in that said first end is the rod head and, should the resistivity increment be lower than the critical value corresponding to a significant donor generation, in that case the remaining portion of the rod in selected to be treated on bipolar device production lines.

4. Method according to claim 3 characterized in that should the resistivity increment be higher than this critical value, steps 1 to 4 are repeated with a new portion approximately adjacent to the first portion and farther from the head of the rod.

5. Method according to claim 3 or 4 characterized in that, for selecting the rods with an oxygen concentration lower than 36 ppmA, the annealing duration close to 2 hours.

6. Method according to claim 1 or 2 characterized in that said first end is the tail of the rod and if the resistivity increment exceeds the critical value which corresponds to a significant donor generation, in that case the remaining portion of the rod is selected to be treated on unipolar device production lines.

7. Method according to claim 6 characterized in that, if the increment is lower than this critical value, steps 1 to 4 are repeated with another portion approximately adjacent to the first portion and farther from the rod tail.

8. Method according to claim 6 or 7 characterized in that selecting the rods with an oxygen concentration exceeding 30 ppmA, the annealing temperature is of 750°C and the annealing duration close to 6 hours.

9. Method according to anyone of the above claims, characterized in that the rod is stabilized at 600°C for 1 to 3 hours.

10. Method according to anyone of the above claims characterized in that the neutral atmosphere consists in nitrogen and in that the etching step includes the removal of the thin layer of surface oxide by rinsing the portion into a bath of acids $NO_3H+HF$.

11. Method according to anyone of above claims 3 to 10, characterized in that the significant donor generation corresponds to the generation of $10^{14}$ donors per $cm^3$.

12. Method according to claim 11 characterized in that the critical value is equal to 3 ohms-cm for a wafer with a resistivity of 19 ohms-cm.

13. Method according to anyone of the above claims, characterized in that the first portion is a 1 cm approx. thick wafer cut from the rod.

**Patentansprüche**

1. Verfahren zur Charakterisierung des Gehaltes an Sauerstoff von nach der Czochralski-Methode gezogenen Siliziumstaeben, die zur Schaffung von Scheiben mit einem kontrollierten Gehalt an Sauerstoff bezweckt sind, dadurch gekennzeichnet, dass es folgende Schritte aufweist:

1) Stabilisierung des spezifischen Widerstands der Staeben,
2) Abschneiden eines ersten in der Nachbarschaft des ersten Stabendes liegenden Stababschnitts und Messung seines spezifischen Widerstands,
3) Anlassen des Stababschnitts bei einer Temperatur zwischen ungefaehr 600° und 900°C lang genug, um Donatoren in einer chemischen neutralen Atmosphaere zu erzeugen,
4) Aetzung dieses Stababschnitts und Ermittlung des Inkrements des spezifischen Widerstands, so dass diesem Inkrement die er-

suchte Anfangskonzentration [Ō] an Sauerstoff entnommen werden kann, die den Sauerstoffgehalt des Stabs charakterisiert.

2. Verfahren nach Anspruch 1, dadurch gekennzeichnet, dass der Temperaturbereich fuer das Anlassen des Stababschnitts zwischen 650° und 850°C liegt, und das Anlassen zwischen 1 und 6 Stunden dauert.

3. Verfahren zur Charakterisierung nach Anspruch 1 oder 2, dadurch gekennzeichnet, dass das erste Ende der Stabkopf ist, und, wenn der Inkrement des spezifischen Widerstands unter den kritischen fuer eine signifikative Donatorengeneration entsprechenden Wert liegt, der uebrige Teil des Stabs infolgedessen ausgewahtl ist, um in den Fertigungslinien von bipolaeren Produkten einzugehen.

4. Verfahren nach Anspruch 3, dadurch gekennzeichnet, dass, wenn der Inkrement des spezifischen Widerstands hoeher als den kritischen Wert ist, die Verfahrenschritte 1 bis 4 auf einem neuen ungefaehr an dem ersten Stababschnitt anliegenden und mit einem groesseren Abstand von dem Stabkopf liegenden Stababschnitt wiederum angewendet sind.

5. Verfahren nach Anspruch 3 oder 4, dadurch gekennzeichnet, dass das Anlassen zur Auswahl von Staeben mit einer kleineren als 36 ppmA Sauerstoffkonzentration bei einer Temperatur von 825°C waehrend ungefaehr 2 Stunden vorgenommen ist.

6. Verfahren nach Anspruch 1 oder 2, dadurch gekennzeichnet, dass das erste Ende das Abschlussende des Stabes ist, und, wenn der Inkrement des spezifischen Widerstands hoeher als den kritischen fuer eine signifikative Donatorengeneration Wert entspricht, der uebrige Teil des Stabs infolgedessen ausgewahlt ist, um in den Fertigungslinien von einpolaeren Produkten einzugehen.

7. Verfahren nach Anspruch 6, dadurch gekennzeichnet, dass wenn der Inkrement des spezifischen Widerstands hoeher als den kritischen Wert ist, die Verfahrenschritte 1 bis 4 auf einem neuen ungefaehr an dem ersten Stababschnitt anliegenden und mit einem groesseren Abstand von dem Stab-Abschlussende liegenden Stababschnitt wiederum angewendet sind.

8. Verfahren nach Anspruch 6 oder 7, dadurch gekennzeichnet, dass das Anlassen zur Auswahl von Staeben mit einer hoeheren als 30 ppmA Sauerstoffkonzentration bei einer Temperatur von 750°C waehrend ungefaehr 6 Stunden vorgenommen ist.

9. Verfahren nach einem der obengenannten Ansprueche, dadurch gekennzeichnet, dass die Stabilisierung des Stabes bei einer Temperatur von 600°C waehrend einer Zweit zwischen 1 und 3 Stunden durchgefuehrt ist.

10. Verfahren nach einem der obengenannten Ansprueche, dadurch gekennzeichnet, dass die Neutralitaetsatmosphaere Stickstoff enthaelt und der Aetzschritt Abscheidung der oberflaechlichen duennen Oxydschicht in einem NO$_3$H+HF enthaltenden Sauerebad einschliesst.

11. Verfahren nach einem der obengenannten Ansprueche 3 bis 10, dadurch gekennezeichnet, dass die signifikative Donatorengeneration der Generation von 10$^{14}$ Donatoren/cm$^3$ entspricht.

12. Verfahren nach Anspruch 11, dadurch gekennzeichnet, dass der kristische Wert fuer eine Scheibe mit einem spezifischen Widerstand von 19 Ohmen/cm 3 Ohmen/cm gleich ist.

13. Verfahren nach einem der obengenannten Anspruch, dadurch gekennzeichnet, dass der erste Stababschnitt eine dicke Stabscheibe ist, deren Dicke ungefaehr 1 cm betraegt.

FIG. 1

FIG. 2

FIG. 3

0 020 993

# FIG . 4

ppma

2

# FIG . 5

# FIG. 6

0 020 993

FIG.7

FIG.8

FIG.9

ppma

MGDH
X10¹⁴/cm³

T

FIG.10

FIG.11

FIG.12

# FIG. 13